## Europäisches Patentamt

## European Patent Office

## Office européen des brevets

(19)

(11) Veröffentlichungsnummer: **0 075 695**
B1

(12) **EUROPÄISCHE PATENTSCHRIFT**

(45) Veröffentlichungstag der Patentschrift:
07.01.87

(51) Int. Cl.⁴: **H 01 L 27/14, H 04 N 3/15**

(21) Anmeldenummer: **82107299.8**

(22) Anmeldetag: **11.08.82**

(54) **Zweidimensionaler Halbleiter-Bildsensor hoher Packungsdichte mit Fotoleiterschicht.**

(30) Priorität: **25.09.81 DE 3138314**

(43) Veröffentlichungstag der Anmeldung:
**06.04.83 Patentblatt 83/14**

(45) Bekanntmachung des Hinweises auf die Patenterteilung:
**07.01.87 Patentblatt 87/2**

(84) Benannte Vertragsstaaten:
**BE FR GB IT NL**

(56) Entgegenhaltungen:
**FR - A - 2 134 042
FR - A - 2 319 182**

**INTERNATIONAL ELECTRON DEVICES MEETING, 3.-5. Dezember 1979, Washington, D.C., Seiten 134-136, IEEE, Washington, US; T. TSUKADA u.a.: "New solid-state Image pickup devices using photosensitive chalcogenide glass film"**

(73) Patentinhaber: **Siemens Aktiengesellschaft Berlin und München, Wittelsbacherplatz 2, D-8000 München 2 (DE)**

(72) Erfinder: **Herbst, Heiner, Dr., Anechostrasse 29a, D-8000 München 82 (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

# Beschreibung

Die Erfindung bezieht sich auf einen zweidimensionalen Halbleiter-Bildsensor mit Fotoleiterschicht nach dem Oberbegriff des Anspruchs 1.

Ein Bildsensor dieser Art ist beispielsweise dem Aufsatz «New Solid-State Image Pickup Devices Using Photosensitive Chalcogenide Glass Film» von T. Tsukuda und anderen aus dem Technical Digest IEDM 1979, Seiten 134–136, bekannt. Dieser Bildsensor weist aus lichtempfindlichen Elementen und Auswahltransistoren bestehende Sensorelemente auf, die in 244 übereinanderliegenden Zeilen zu je 320 Elementen auf einer Bildfläche von 8,8 mm × 6,6 mm integriert sind. Unter Bildfläche wird hierbei jene Halbleiterfläche verstanden, auf die eine auszuwertende Abbildung projiziert wird.

Der Erfindung liegt die Aufgabe zugrunde, einen Bildsensor der eingangs genannten Art anzugeben, der die bekannten Bildsensoren im Hinblick auf die Packungsdichte der Sensorelemente noch übertrifft. Dies wird durch eine Ausbildung gemäss dem kennzeichnenden Teil des Anspruchs 1 erreicht.

Der mit der Erfindung erzielbare Vorteil besteht insbesondere darin, dass die Abmessung der Bildfläche des Bildsensors bei einer vorgegebenen Anzahl von aufintegrierten Sensorelementen in Richtung der Spaltenleitungen wesentlich kleiner ist als bei den bekannten Bildsensoren oder dass bei vorgegebenen Abmessungen der Bildfläche wesentlich mehr Sensorelemente aufintegriert werden können.

Die Ansprüche 2 und 3 sind auf bevorzugte Weiterbildungen der Erfindung gerichtet.

Die Erfindung wird nachfolgend anhand der Zeichnung näher erläutert. Dabei zeigt:

Fig. 1 einen Teil eines erfindungsgemäss ausgebildeten Bildsensors im Querschnitt und

Fig. 2 eine Draufsicht auf einen Bildsensor nach der Erfindung im Bereich einiger nebeneinander liegender Sensorelemente.

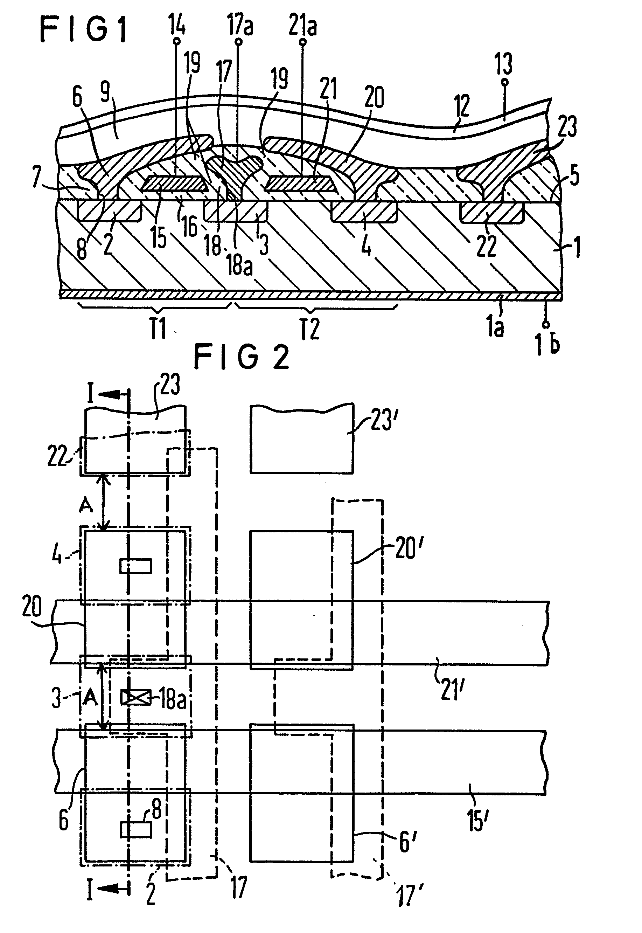

In Fig. 1 ist ein Halbleiterkörper 1 eines ersten Leitungstyps, z.B. aus p-dotierten Silizium, im Schnitt dargestellt. Er weist eine Substratelektrode 1a mit einem Anschluss 1b auf. In den Halbleiterkörper 1 sind Halbleitergebiete 2 bis 4 eines zweiten Leitungstyps, z.B. $n^+$-dotierte Gebiete, eingefügt, die sich bis zur Grenzfläche 5 erstrecken. Mit dem Gebiet 2 ist eine Ankoppelelektrode 6 aus elektrisch leitendem Material, z.B. Aluminium, verbunden, die durch eine elektrisch isolierende Schicht 7, z.B. aus $SiO_2$, von der Grenzfläche 5 getrennt ist und lediglich im Bereich eines Kontaktlochs 8 das Gebiet 2 kontaktiert. Über der Ankoppelelektrode 6 liegt eine durchgehende hochohmige Fotoleiterschicht 9, die in an sich bekannter Weise aufgebaut ist, z.B. aus einer amorphen Schicht aus Se-As-Te (Selen-Arsen-Tellur). Auf der Fotoleiterschicht 9 ist ganzflächig eine transparente Deckelektrode 12 aufgebracht, die mit einem Anschluss 13 versehen ist.

Das Gebiet 2 ist das eine Anschlussgebiet eines Auswahltransistors T1, der ein mit einem Anschluss 14 versehenes Gate 15 aus einem elektrisch leitenden Material, z.B. polykristallinem, hochdotiertem Silizium, aufweist, das durch eine dünne Schicht 16 aus elektrisch isolierendem Material, z.B. $SiO_2$, von der Grenzfläche 5 getrennt ist. Das Gebiet 3 stellt das zweite Anschlussgebiet von T1 dar und ist mit einer Spaltenleitung 17 verbunden, die mit einem Anschluss 17a versehen ist. Die Spaltenleitung 17 ist durch eine elektrisch isolierende Schicht 18 von der Grenzfläche 5 getrennt und kontaktiert das Anschlussgebiet 3 lediglich im Bereich eines Kontaktlochs 18a. Mit 19 ist eine elektrisch isolierende Zwischenschicht bezeichnet, die die leitenden Teile 6, 15 und 17 voneinander trennt.

Das aus den Teilen 6, 9 und 12 bestehende lichtempfindliche Element, das wegen der Hochohmigkeit der Fotoleiterschicht im wesentlichen auf die lateralen Abmessungen der Ankoppelelektrode 6 begrenzt ist, bildet zusammen mit dem Auswahltransistor T1 ein erstes Sensorelement. Ein weiteres Sensorelement ist in analoger Weise aus einer Ankoppelelektrode 20, der Fotoleiterschicht 9, der Deckelektrode 12, den Halbleitergebieten 3 und 4 und einem Gate 21 aus metallisch leitendem Material aufgebaut. Die Teile 3, 21 und 4 bilden einen weiteren Auswahltransistor T2, wobei das Gebiet 3 ein gemeinsames Anschlussgebiet für T1 und T3 darstellt.

Belegt man den Anschluss 13 mit einer positiven Spannung von etwa 40V, so sammeln sich unter Lichteinwirkung auf der Ankoppelelektrode 6 und im Halbleitergebiet 2 Ladungsträger an, die beim Anliegen einer positiven Spannung an 14 und einer positiven Spannung an 17a über den leitend geschalteten Transistor T1 und die Spaltenleitung 17 ausgelesen werden. In entsprechender Weise werden auch die Ladungsträger, die sich unter Lichteinfluss in den Teilen 20 und 4 ansammeln, durch Zuführung von positiven Spannungen an die Anschlüsse 21a und 17a über die Spaltenleitung 17 ausgelesen.

Im rechten Teil der Fig. 1 ist ein weiteres Halbleitergebiet 22 des zweiten Leitungstyps dargestellt, das mit einer Ankoppelelektrode 23 verbunden ist. Diese Teile gehören zu einem weiteren Sensorelement, das entsprechend dem zuerst beschriebenen aufgebaut ist.

Die in Fig. 2 gezeigte Draufsicht auf den Halbleiterkörper 1 lässt die laterale Ausbildung der Struktur nach Fig. 1 erkennen. Der in Fig. 1 dargestellte Schnitt verläuft längs der Linie I–I von Fig. 2, wobei auch die Halbleitergebiete 2, 3, 4 und 22 auf dieser vertikalen Linie bzw. in einer Spalte des Halbleiter-Bildsensors liegen. Die Begrenzungen dieser Gebiete sind in Fig. 2 strichpunktiert gezeichnet. Mit 15' und 21' sind Zeilenleitungen angedeutet, deren die Halbleiterbereiche zwischen den Gebieten 2 und 3 bzw. 3 und 4 überdeckende Abschnitte die in Fig. 1 dargestellten Gates 15 und 21 bilden. Die Zeilenleitungen 15' und 21' verlaufen in horizontaler Richtung, während die Spaltenleitung 17, die in Fig. 2 gestrichelt gezeichnet ist, in vertikaler Richtung verläuft. Der in Fig. 1 dargestellte Teil der Spaltenleitung 17 ist in Fig. 2 als horizontaler, d.h. in Richtung der Zeilenleitungen verlaufender Ansatz erkennbar, der zu dem Kontaktloch 18a hinführt.

Die an den einander benachbarten Zeilenleitungen 15′ und 21′ liegenden Sensorelemente der auf der linken Seite der Fig. 2 dargestellten Spalte sind in der Weise zusammengefasst, dass ihre Auswahltransistoren ein gemeinsames Anschlussgebiet 3 haben, das über das Kontaktloch 18a mit der Spaltenleitung 17 verbunden ist.

Es ist bei erfindungsgemäss ausgebildeten Sensorelementen besonders zweckmässig, die Ankoppelelektroden, z.B. 6 und 20, zweier in der beschriebenen Weise zusammengefasster Elemente in Richtung aufeinander soweit zu verlängern, dass sich zwischen ihren einander zugekehrten Kanten ein Abstand A ergibt, der gleich ist dem Abstand zu den anderen jeweils benachbarten Sensorelementen in Spaltenrichtung.

Dies ist in Fig. 2 durch die eingezeichneten Abstände A verdeutlicht. In Fig. 2 sind ferner die Koppelelektroden 6′, 20′ und 23′ weiterer Sensorelemente angedeutet, die in einer weiteren Spalte des Bildsensors liegen und mit einer Spaltenleitung 17′ verbindbar sind.

In Abweichung von der beschriebenen Ausführungsform kann die Spaltenleitung 17 auch durch eine in den Halbleiterkörper 1 eingefügte, insbesondere eindiffundierte $n^+$-dotierte Leitung ersetzt sein, die mit dem gemeinsamen Anschlussgebiet 3 der Auswahltransistoren T1 und T2 in Verbindung steht.

Die Fotoleiterschicht 9 kann beispielsweise auch aus zwei Teilschichten aufgebaut sein, von denen die eine aus Zink-Tellurid und Cadmium-Tellurid besteht ($Zn_{1-x}Cd_xTe$) und die andere aus Zink-Selenid (ZnSe) gebildet ist. In diesem Fall wird der aus Indium-Zinn-Oxid bestehenden Deckelektrode 12 über den Anschluss 13 eine solche Spannung zugeführt, dass der zwischen den beiden Teilschichten bestehende pn-Übergang in Sperrichtung vorgespannt ist. Ein solcher Aufbau der Fotoleiterschicht ist an sich bekannt und beispielsweise in dem Digest of Technical Papers der ISSCC 1980, Seiten 34–35, beschrieben.

**Patentansprüche**

1. Zweidimensionaler Halbleiter-Bildsensor mit auf einem dotierten Halbleiterkörper (1) eines ersten Leitungstyps integrierten, in Zeilen und Spalten angeordneten Sensorelementen, bei dem die Sensorelemente jeweils aus einem Feldeffekt-Auswahltransistor (T1) mit isoliertem Gate (15) und einem lichtempfindlichen Element bestehen, das einen Teil einer Fotoleiterschicht (9) darstellt und zwischen einer transparenten Deckelektrode (12) und einer mit dem Auswahltransistor verbundenen Ankoppelelektrode (6) liegt, bei dem Zeilenleitungen und Spaltenleitungen vorgesehen sind, von denen die Zeilenleitungen (15′) mit den Gates (15) der Auswahltransistoren beschaltet sind und die Spaltenleitungen (17) mit Anschlussgebieten der Auswahltransistoren leitend verbunden sind, dadurch gekennzeichnet, dass die Sensorelemente benachbarter Zeilen (15′, 21′) spaltenweise zusammengefasst sind, wobei die Anschlussgebiete der Auswahltransistoren jeweils zweier der gleichen Spaltenleitung (17) zugeordneter Sensorelemente aus einem einzigen, beiden Sensorelementen gemeinsamen Halbleitergebiet (3) bestehen, das mit der Spaltenleitung (17) verbunden ist.

2. Zweidimensionaler Halbleiter-Bildsensor nach Anspruch 1, dadurch gekennzeichnet, dass die Spaltenleitung (17) auf einer auf dem Halbleiterkörper aufgebrachten isolierenden Schicht angeordnet ist und im Bereich eines Kontaktlochs (18a) mit dem beiden Sensorelementen gemeinsamen Halbleitergebiet (3) verbunden ist.

3. Zweidimensionaler Halbleiter-Bildsensor nach Anspruch 1 oder 2, dadurch gekennzeichnet, dass das beiden Sensorelementen gemeinsame Halbleitergebiet (3) mit einem ansatzartigen Teil der Spaltenleitung (17) verbunden ist, das in Richtung der Zeilenleitungen (15′, 21′) verläuft.

**Claims**

1. A bi-dimensional semiconductor image sensor comprising sensor elements which are integrated in a doped semiconductor body (1) of a first conductivity type and are arranged in rows and columns, where the sensor elements each consists of a field effect selector transistor (T1) which has an insulated gate (15) and a light-sensitive element which represents part of a photoconductor layer (9) and is located between a transparent top electrode (12) and a coupling electrode (6) which is connected to the selector transistor, where row lines and column lines are provided, of which the row lines (15′) are connected to the gates (15) of the selector transistors and the column lines (17) are conductively connected to terminal zones of the selector transistors, characterised in that the sensor elements of adjacent rows (15′, 21′) are combined in columns, where the terminal zones of the selector transistors of two sensor elements assigned to same column line (17), consist of a single semiconductor zone (3) which is common to both sensor elements and which is connected to the column line (17).

2. A bidimensional semiconductor image sensor as claimed in Claim 1, characterised in that the column line (17) is arranged on an insulating layer which is applied to the semiconductor body and, in the region of a contact hole (18a), is connected to the semiconductor zone (3) which is common to both sensor elements.

3. A bidimensional semiconductor image sensor as claimed in Claim 1 or Claim 2, characterised in that the semiconductor zone (3) which is common to both sensor elements is connected to an appendage-like part of the common line (17) which runs in the direction of the row lines (15′, 21′).

## Revendications

1. Détecteur d'image à semiconducteur, du type bidimensionnel, avec des éléments-détecteurs disposés en lignes et en colonnes et intégrés sur un corps semiconducteur dopé (1) et présentant un premier genre de conductivité, dans lequel les éléments-détecteurs sont chacun constitués par un transistor à effet de champ à sélection (T1) comportant une grille isolée (15) et un élément photosensible qui représente une partie d'une couche photoconductrice (9) et est situé entre une électrode de couverture (12) et une électrode de couplage (9) reliée au transistor de sélection, dans lequel sont prévus des conducteurs de lignes et des conducteurs de colonnes, les conducteurs de lignes (15') étant reliés de façon conductrice aux grilles (15) des transistors de sélection et les conducteurs de colonnes (17) étant reliés de façon conductrice à des zones de branchement des transistors de sélection, caractérisé par le fait que les éléments-détecteurs de lignes voisines (15', 21') sont rassemblés en colonnes, les zones de branchement des transistors de sélection de deux éléments-détecteurs associés au même conducteur de colonne (17) étant constituées par une zone semiconductrice (3) commune aux deux éléments-détecteurs et reliées à la ligne de colonne (17).

2. Détecteur d'image à semiconducteur, du type bidimensionnel, selon la revendication 1, caractérisé par le fait que le conducteur de colonne (17) est disposé sur une couche isolante déposée sur le corps semiconducteur et que dans la zone d'un trou de contact (18a), il est relié à la zone semiconductrice (3) qui est commune aux deux éléments-détecteurs.

3. Détecteur d'image à semiconducteur, du type bidimensionnel, selon la revendication 1 ou 2, caractérisé par le fait que la zone semiconductrice (3) qui est commune aux deux éléments-détecteurs, est reliée avec un élément, en forme d'appendice du conducteur de colonne (17), qui s'étend en direction des conducteurs de lignes (15', 21').

FIG 1

FIG 2